(19) Europäisches Patentamt
European Patent Office
Office européen des brevets

(11) Publication number: **0 088 842**
**B1**

# (12) EUROPEAN PATENT SPECIFICATION

(45) Date of publication of patent specification: **02.01.86**

(51) Int. Cl.[4]: **C 08 G 77/40,** C 08 F 2/50, C 08 L 83/06 // G03C1/68

(21) Application number: **82301336.2**

(22) Date of filing: **16.03.82**

## (54) Organopolysiloxane photosensitizers and methods for their preparation.

(43) Date of publication of application:
**21.09.83 Bulletin 83/38**

(45) Publication of the grant of the patent:
**02.01.86 Bulletin 86/01**

(84) Designated Contracting States:
**DE FR GB IT**

(56) References cited:
**GB-A-1 213 779**
**GB-A-1 569 681**

(73) Proprietor: **Toray Silicone Company Limited**
**2-8 Nihonbashi Muromachi**
**Chuo-ku Tokyo 103 (JP)**

(72) Inventor: **Shirahata, Akihiko**
**1-6 Yushudai-nishi**
**Ichihara-shi Chiba-ken (JP)**
Inventor: **Kishimoto, Keiichi**
**3-5-14 Aobadai**
**Ichihara-shi Chiba-ken (JP)**

(74) Representative: **Laredo, Jack Joseph et al**
**Elkington and Fife High Holborn House 52/54**
**High Holborn**
**London, WC1V 6SH (GB)**

**EP 0 088 842 B1**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

**Description**

This invention relates to novel photopolymerization sensitizers and to methods for their preparation comprising bonding benzophenone derivatives into organopolysiloxanes.

Various photosensitive or photopolymerizable (hereafter to be called photosensitive) resins are conventionally known. Several photopolymerization sensitizers have been developed or proposed for the photopolymerization of these photosensitive resins. The required characteristics for these photopolymerization sensitizers are good sensitizing action and good miscibility with the photosensitive resins. If its miscibility with photosensitive resins is poor, the polymerization sensitizer will separate from the photosensitive resins and the desired sensitization action cannot then be adequately achieved. When the photosensitive resin polymerizes and hardens, nonuniformities therein are formed and the sensitizer is deposited or separated from the hardened photosensitive resin. In cases where photosensitive resins blended with the photopolymerization sensitizer are stored, long-term storage is a problem.

There are many types of conventionally known photosensitive silicone resins and photosensitive organopolysiloxanes and it is necessary to use photopolymerization sensitizers with these resins. For this purpose, sensitizers such as 2,6-dichloro-4-nitroaniline, 2,4-dinitrophenol and other aromatic compounds; Michler's ketone, benzophenone, benzoin, and other ketones; and benzoquinone and other quinones are known to be effective. However, these sensitizers have the drawbacks and disadvantages described above since they are poorly miscible with photosensitive organopolysiloxanes. Sensitizers which are miscible with photosensitive organopolysiloxanes have been proposed in Japanese Patent Sho 51 (1976)—48794. They are benzophenone derivatives substituted with organosiloxy groups. However, they are not perfectly miscible with photosensitive organopolysiloxanes and their syntheses are also time-consuming. Therefore, they have no practical use. This invention was achieved as the result of research by the present inventors in order to overcome these disadvantages of the conventional technologies.

It is an object of this invention to provide novel organopolysiloxane photosensitizers. It is another object of this invention to provide photosensitizers which are readily miscible with photosensitive silicone resins and with photosensitive organopolysiloxanes. It is a further object of this invention to provide photosensitizers which are relatively easily prepared and methods for their preparation.

These objects, and others which will become obvious after considering the following specification and appended claims, are obtained by chemically bonding certain alkenyloxy-substituted benzophenone derivatives to organopolysiloxanes or organosilanes which bear silicon-bonded hydrogen atoms and optionally, further polymerizing the product by a siloxane-polymerizing reaction.

Detailed description of the invention

The present invention relates to an organopolysiloxane photosensitizer comprising an average of more than two siloxane units, of which at least an average of one siloxane unit per organopolysiloxane molecule has the formula $Q_aR^4_bSiO_{(4-a-b)/2}$, wherein Q denotes a benzophenone-containing group having the formula

$$(R^1_mC_6H_{5-m})\overset{\overset{\displaystyle O}{\|}}{C}(C_6H_{4-n}R^2_nOR^3\!\!-\!\!\!\!+;$$

$R^1$ and $R^2$ each denote, independently, a hydrogen atom, a halogen atom, a monovalent hydrocarbon group having from 1 to 10 carbon atoms, an alkoxy group, a thioalkoxy group, a hydroxyl group, an amino group or a dialkylamino group; $R^3$ denotes a divalent hydrocarbon group having from 2 to 10 carbon atoms; $R^4$ denotes a monovalent hydrocarbon group or a halogenated monovalent hydrocarbon group; *m* is an integer of from 1 to 5, *n* is an integer of from 1 to 4, *a* is an integer of from 1 to 3, *b* is an integer of from 0 to 2 and *a*+*b* is an integer of from 1 to 3.

The present invention further relates to a method for preparing an organopolysiloxane photosensitizer comprising an average of more than two siloxane units, of which at least an average of one siloxane unit per organopolysiloxane molecule has the formula $Q_aR^4_bSiO_{(4-a-b)/2}$, said method comprising reacting, by a hydrosilylation reaction, an alkenyloxybenzophenone reactant having the formula

$$(R^1_mC_6H_{5-m})\overset{\overset{\displaystyle O}{\|}}{C}(C_6H_{4-n}R^2_nOR^5)$$

and an organohydrogenpolysiloxane reactant containing more than two siloxane units and at least one silicon-bonded hydrogen atom per molecule, wherein Q denotes a benzophenone-containing group having the formula

$$(R^1_mC_6H_{5-m})\overset{\overset{\displaystyle O}{\|}}{C}(C_6H_{4-n}R^2nOR^3\!\!-\!\!\!\!+;$$

at each occurrence $R^1$ and $R^2$ denote, independently, a hydrogen atom, a halogen atom, a monovalent hydrocarbon group having from 1 to 10 carbon atoms, an alkoxy group, a thioalkoxy group, a hydroxyl group, an amino group or a dialkylamino group; $R^3$ denotes a divalent hydrocarbon group having from 2 to 10 carbon atoms; $R^4$ denotes a monovalent hydrocarbon group or a halogenated monovalent hydrocarbon group; $R^5$ denotes an aliphatically unsaturated monovalent hydrocarbon group having the same number of carbon atoms as the $R^3$ group; *m* is an integer of from 1 to 5, *n* is an integer of from 1 to 4, *a* is an integer of from 1 to 3, *b* is an integer of from 0 to 2 and *a*+*b* is an integer of from 1 to 3; the $R^5$ group becoming the $R^3$ group during said hydrosilylation reaction.

The present invention also relates to a method for preparing an organopolysiloxane photosensitizer comprising an average of more than two siloxane units, of which an average of at least one siloxane unit per organopolysiloxane molecule has the formula $Q_aR^4_bSiO_{(4-a-b)/2}$, said method comprising (A) reacting, by a hydrosilylation reaction to form an adduct, an alkenyloxybenzophenone reactant having the formula

$$(R^1_mC_6H_{5-m})\overset{O}{\overset{||}{C}}(C_6H_{4-n}R^2_nOR^5)$$

and a silane bearing at least one silicon-bonded hydrogen atom and at least one silicon-bonded hydrolyzable group or a siloxane bearing at least two siloxane units and at least one silicon-bonded hydrogen atom; and (B) polymerizing the adduct or copolymerizing the adduct with another silane bearing at least one silicon-bonded hydrolyzable radical or with a siloxane, both being free of Q groups, to provide the organopolysiloxane photosensitizer, wherein Q denotes a benzophenone-containing group having the formula

$$(R^1_mC_6H_{5-m})\overset{O}{\overset{||}{C}}(C_6H_{4-n}R^2nOR^3\!\!-\!\!\!\!+);$$

at each occurrence $R^1$ and $R^2$ denote, independently, a hydrogen atom, a halogen atom, a monovalent hydrocarbon group having from 1 to 10 carbon atoms, an alkoxy group, a thioalkoxy group, a hydroxyl group, an amino group or a dialkylamino group; $R^3$ denotes a divalent hydrocarbon group having from 2 to 10 carbon atoms; $R^4$ denotes a monovalent hydrocarbon group or a halogenated monovalent hydrocarbon group; $R^5$ denotes an aliphatically unsaturated monovalent hydrocarbon group having the same number of carbon atoms as the $R^3$ group; *m* is an integer of from 1 to 5, *n* is an integer of from 1 to 4, *a* is an integer of from 1 to 3, *b* is an integer of from 0 to 2 and *a*+*b* is an integer of from 1 to 3; the $R^5$ group becoming the $R^3$ group during said hydrosilylation reaction.

The photopolymerization sensitizers of the present invention are organopolysiloxanes having an average of at least one siloxane unit per molecule which bears a silicon-bonded benzophenone derivative group. This siloxane unit has the formula $Q_aR^4_bSiO_{(4-a-b)/2}$ wherein Q represents the benzophenone derivative group and has the formula

$$(R^1_mC_6H_{5-m})\overset{O}{\overset{||}{C}}(C_6H_{4-n}R^2_nOR^3\!\!-\!\!\!\!+).$$

In the above siloxane unit formula *a* has a value of 1, 2 or 3, *b* has a value of 0, 1 or 2 and the sum of *a*+*b* has a value of 1, 2 or 3, thereby providing siloxane units having the formulae $QSiO_{3/2}$, $QR^4SiO_{2/2}$, $QR^4_2SiO_{1/2}$, $Q_2SiO_{2/2}$, $Q_2R^4SiO_{1/2}$ and $Q_3SiO_{1/2}$. Preferably, *a* has a value of 1, as illustrated by the first three siloxane units listed.

In the above formula for Q, $R^1$ and $R^2$ each denote hydrogen atoms, hydroxyl groups, amino groups, halogen atoms such as fluorine, chlorine, bromine and iodine; monovalent hydrocarbon groups containing 1—10 carbons such as methyl groups, ethyl groups, n-propyl groups, n-butyl groups, t-butyl groups, hexyl groups and octyl groups; alkoxy groups such as methoxy groups, ethoxy groups and propoxy groups; thioalkoxy groups, such as thiomethoxy groups and thioethoxy groups; and dialkylamino groups, such as dimethylamino groups, diethylamino groups and methylpropylamino groups. In a preferred embodiment of this invention, $R^1$ and $R^2$ are hydrogen atoms.

In the above formula for Q, *m* has a value of from 1 to 5, preferably from 1 to 3, and *n* has a value of from 1 to 4, preferably from 1 to 3. Of course, in the preferred embodiment wherein $R^1$ and $R^2$ both are hydrogen, the values of *m* and *n* are effectively, and equivalently, any and all values from 0 to 5 and 0 to 4 respectively.

$R^3$ denotes a divalent hydrocarbon group having from 2 to 10 carbon atoms such as ethylene groups, propylene groups, isopropylene groups and butylene groups. Preferably, $R^3$ is a propylene group.

A highly preferred Q group, therefore, has the formula

$$C_6H_5\overset{\overset{\large O}{||}}{C}C_6H_4OCH_2CH_2CH_2.$$

In the above siloxane unit formula, $R^4$ denotes a monovalent hydrocarbon group or a halogenated monovalent hydrocarbon group. Examples of suitable monovalent hydrocarbon groups include alkyl groups such as methyl groups, ethyl groups, propyl groups and octyl groups; aryl groups such as phenyl groups, tolyl groups and xylyl groups; cycloaliphatic groups such as cyclohexyl groups; and arylalkyl groups such as benzyl groups, 2-phenylethyl groups and 2-phenylpropyl groups. Examples of suitable halogenated monovalent hydrocarbon groups include 3-chloropropyl groups, 3-chloro-2-methylpropyl groups, 3,3,3-trifluoropropyl groups and chlorophenyl groups.

The organopolysiloxane sensitizers of this invention can contain, in addition to siloxane units bearing Q groups, siloxane units which are free of Q groups. Said siloxane units free of Q groups preferably have the formula $R^4_cH_dSiO_{(4-c-d)/2}$ wherein $R^4$ denotes those groups delineated above. The values of *c*, *d* and *c+d* can be, independently, 0, 1, 2 or 3. Preferably, *c* has a value of 1, 2 or 3 and *d* has a value of 0 or 1 thereby providing siloxane units having the formulae $R^4SiO_{3/2}$, $R^4_2SiO_{2/2}$, $R^4_3SiO_{1/2}$, $R^4HSiO_{2/2}$ and $R^4_2HSiO_{1/2}$.

Examples of suitable siloxane units free of Q groups include dimethylsiloxane, methylvinylsiloxane, methylphenylsiloxane, diphenylsiloxane, methyloctylsiloxane, methyl(3,3,3-trifluoropropyl)siloxane, methyl(3-chloropropyl)siloxane, and other diorganosiloxanes; trimethylsiloxane, dimethylvinylsiloxane, dimethylphenylsiloxane, methylphenylvinylsiloxane, dimethyl(3,3,3-trifluoropropyl)siloxane, and other triorganosiloxanes; methylsiloxane, propylsiloxane, vinylsiloxane, phenylsiloxane, 3,3,3-trifluoropropylsiloxane, and other monoorganosiloxanes; methyl hydrogen siloxane, dimethylhydrogen siloxane, hydrogen siloxane, and other siloxanes containing hydrogen atoms directly bonded to silicon atoms.

The structure of the organopolysiloxane photosensitizer can be linear, branched, cyclic, or network. Its degree of polymerization, i.e. the number of siloxane units, is greater than 2 with an upper limit as high as the maximum possible degree of polymerization, generally about 10,000. However, it is preferable for the degree of polymerization to be less than 1,000 from the viewpoint of the miscibility of the sensitizer. It is sufficient that each molecule have at least one group possessing the benzophenone derivative structure. It is also sufficient that each molecule have at least one organosiloxane unit containing this group. At the upper limit, the organosiloxane units can all contain a group possessing the benzophenone derivative structure. Nevertheless, if the number of the groups possessing the benzophenone derivative structure is too low, sensitization will be insufficient. If the number is too high, the miscibility with photosensitive resins, especially with photosensitive silicone resins and photosensitive organopolysiloxanes, will decrease. Therefore, it is preferable to have this group present at 0.2% to 50% of the total number of organic groups ($R^4$+Q) in each molecule.

A preferred embodiment of the present invention is an organopolysiloxane photosensitizer wherein all $R^4$ groups are methyl groups. The resulting methyl-containing photosensitizers are particularly useful in the methyl silicone photocurable resins delineated below.

A particularly useful embodiment of the present invention is the fluid organopolysiloxane photosensitizers, illustrated by the examples disclosed below and encompassed by the general formula

$$R^4_3SiO(R^4_2SiO)_x(R^4HSiO)_y(R^4QSiO)_zSiR^4_3.$$

Herein $R^4$ and Q are as delineated above, preferably $CH_3$ and

$$C_6H_5\overset{\overset{\large O}{||}}{C}C_6H_4OCH_2CH_2CH_2-$$

respectively, and *x*, *y* and *z* have average values such that their sum is less than 1000 and *z* is at least 1. The values of *x* and *y* can both be zero; however the value of *x* is typically greater than zero.

The organopolysiloxane photosensitizers of this invention can be prepared by two general methods, both comprising a hydrosilylation reaction between an alkenyloxybenzophenone reactant and a reactant bearing at least one siliconbonded hydrogen atom, and both comprising an aspect of this invention. Other methods of preparation may also be suitable.

In these two general methods of preparation the alkenyloxybenzophenone reactant has the formula

$$(R^1_mC_6H_{5-m})\overset{\overset{\large O}{||}}{C}(C_6H_{4-n}R^2_nOR^5)$$

wherein $R^1$ and $R^2$ denote the same general and preferred groups denoted above and *m* and *n* denote the same general and preferred integers noted above. These groups and integers are carried, unchanged in these two general methods, from the alkenyloxybenzophenone reactant into the organopolysiloxane photosensitizer.

The $R^5$ group of the alkenyloxybenzophenone reactant is an aliphatically unsaturated monovalent hydrocarbon group having the same number of carbon atoms, i.e. 2 to 10, as the $R^3$ group denoted above and becomes said $R^3$ group after the hydrosilylation reaction with the silicon-bonded hydrogen atom. Examples of suitable $R^5$ groups include $-CH=CH_2$, $-CH_2CH=CH_2$,

$$\begin{array}{c} \quad CH_3 \\ \quad | \\ -CH_2C=CH_2, \end{array}$$

and $-CH_2CH=CHCH_3$.

Of course, it is to be understood that whereas a given $R^5$ group provides an $R^3$ group having the same number of carbon atoms after the hydrosilylation reaction, the structure of the resulting $R^3$ group can vary. For example, an $R^5$ group having the structure $-CH_2CH=CH_2$ group can provide an $R^3$ group having the structure

$$-CH_2CH_2CH_2- \text{ or } \begin{array}{c} \;\;| \\ -CH_2CHCH_3, \end{array}$$

depending on the mode of addition of the reacting silicon atom and the reacting hydrogen atom of the reactant bearing at least one silicon-bonded hydrogen atom.

Examples of alkenyloxybenzophenone derivatives are o - vinyloxybenzophenone, p - vinyloxybenzophenone, o - allyloxybenzophenone, p - allyloxybenzophenone, 2 - allyloxy - 4 - methoxybenzophenone, 4,4' - diallyloxybenzophenone, 3,5 - dichloro - 4 - allyloxybenzophenone, 2 - allyloxy - 5 - methylbenzophenone, o - methallyloxybenzophenone, p - methallyloxybenzophenone, 2 - methallyloxy - 4 - methoxybenzophenone, 4,4' - dimethallyloxybenzophenone, 3,5 - dichloro - 4 - methallyloxybenzophenone, 2 - methallyloxy - 5 - methylbenzophenone, o - crotyloxybenzophenone, p - crotyloxybenzophenone, 2 - crotyloxy - 4 - methoxybenzophenone, 4,4' - dicrotyloxybenzophenone, 3,5 - dichloro - 4 - crotyloxybenzophenone, and 2 - crotyloxy - 5 - methylbenzophenone.

The alkenyloxybenzophenone derivative to be used in this synthesis can be synthesized by a conventionally known ether-linkage-formation reaction between readily available substituted or unsubstituted hydroxybenzophenone and an alkenyl halide. In other words, it can be obtained by a reaction between the substituted or unsubstituted hydroxybenzophenone and an alkenyl halide by use of a solvent such as ether, tetrahydrofuran, acetone, dimethoxy ethane, dimethylsulfoxide, or dimethylformamide in the presence of a base such as sodium amide, potassium carbonate, triethylamine, sodium hydroxide, potassium hydroxide, barium oxide, silver oxide, or sodium hydride. If necessary, a catalyst such as an iodide, for example, potassium iodide, can be added. Examples of specific hydroxybenzophenone derivatives are o-hydroxybenzophenone, p-hydroxybenzophenone, 2-hydroxy-4-methoxybenzophenone, 4,4'-dihydroxybenzophenone, 3,5-dichloro-4-hydroxybenzophenone, and 2-hydroxy-5-methylbenzophenone. Examples of alkenyl halides are vinyl chloride, allyl chloride, allyl bromide, methallyl chloride, and crotyl chloride.

In a first of said two general methods for preparing the organopolysiloxane photosensitizers of this invention the alkenyloxybenzophenone reactant is reacted with an organohydrogenpolysiloxane reactant bearing at least one silicon-bonded hydrogen atom to provide the organopolysiloxane photosensitizers of this invention.

The organohydrogenpolysiloxane reactant used in the hydrosilylation reaction can be straight chained, branched chained, cyclic or network. The degree of polymerization is greater than 2 and can go as high as the maximum possible degree of polymerization which can take place without destroying the hydrogen-silicon bonds. For the reasons noted above for the organopolysiloxane photosensitizers of this invention, however, the degree of polymerization of the organohydrogenpolysiloxane reactant is likewise preferably less than 1000.

The organohydrogenpolysiloxane reactant is preferably composed of siloxane units having the formula $R^4_cH_dSiO_{(4-c-d)/2}$ wherein $R^4$, $c$, $d$, and $c+d$ having the same general and preferred meanings as noted above with the requirement that at least one of the siloxane units bears a silicon-bonded hydrogen atom.

A preferred organohydrogenpolysiloxane to be used in this first method of photosensitizer preparation has the formula

$$R^4_3SiO(R^4_2SiO)_x(R^4HSiO)_wSiR^4_3$$

wherein $x$ and $w$ denote integers whose sum has a value of less than 1000. After the hydrosilylation reaction with the alkenyloxybenzophenone reactant, this preferred organohydrogenpolysiloxane will give rise to the preferred organopolysiloxane photosensitizer noted above and having the formula

$$R^4_3SiO(R^4_2SiO)_x(R^4HSiO)_y(R^4QSiO)_z\text{—}SiR^4_3$$

wherein the sum of $y+z$ has a value equal to the value of $w$. To obtain the methyl-containing

organopolysiloxane photosensitizers that are particularly useful in methyl silicone photocurable resins referred to above and delineated below, all $R^4$ groups in the organohydrogenpolysiloxane reactant are methyl groups. Additionally, the alkenyloxybenzophenone reactant preferably has the formula

$$C_6H_5\overset{\overset{O}{\|}}{C}C_6H_4OCH_2CH{=}CH_2.$$

As noted above, *x* can have a value of zero; however, it is typically greater than zero in the organohydrogenpolysiloxane reactant. Also, as noted above, *y* can have a value of zero, a condition resulting from the complete reaction of silicon-bonded hydrogen atoms with alkenyloxybenzophenone, and the value of *w* then equals the value of *z*.

In a second of said two general methods for preparing the organopolysiloxane photosensitizers of this invention an alkenyloxybenzophenone reactant is first reacted, by a hydrosilylation reaction, with a silane which contains at least one silicon-bonded hydrogen atom and at least one silicon-bonded hydrolyzable group or with a siloxane bearing at least two siloxane units and at least one silicon-bonded hydrogen atom. The resulting reaction product, herein designated as the adduct, is thereafter polymerized with itself or with another silane bearing at least one silicon-bonded hydrolyzable group or with another siloxane. Said another silane and said another siloxane are free of silicon-bonded benzophenone-containing groups.

In this second method the alkenyloxybenzophenone reactant is the same as the general and preferred structures described in the first method, above.

The silane reactant containing hydrogen atoms bonded to silicon atoms for the addition reaction with the alkenyloxybenzophenone reactant in said second method preferably has the formula $R^4_eHSiZ_{3-e}$. The $R^4$ groups in this formula are the same as noted above. Z denotes a hydrolyzable group such as a halogen atom, preferably a chlorine atom; or an alkoxy group such as a methoxy group or an ethoxy group, or an acyloxy group such as an acetoxy group or a propionoxy group. The value of *e* is 0, 1 or 2, thereby providing silanes such as $HSiZ_3$ such as trichlorosilane or trimethoxysilane, $R^4$ $HSiZ_2$ such as methyldichlorosilane or methyldimethoxysilane or methyldiacetoxysilane, and $R^4_2HSiZ$ such as dimethylchlorosilane. The adduct resulting from the hydrosilylation reaction between the alkenyloxybenzophenone reactant and the preferred silane reactant has the formula $R^4_eQSiZ_{3-e}$ wherein $R^4$, Q, Z and *e* are as described above. Examples of suitable silane adducts include, but are not limited to, $QSiZ_3$ such as $QSiCl_3$ or $QSi(OCH_3)_3$, $(CH_3)QSiZ_2$ such as $(CH_3)QSiCl_2$ or $(CH_3)QSi(OCH_3)_2$ or

$$(CH_3)QSi(O\overset{\overset{O}{\|}}{C}CH_3)_2$$

and $(CH_3)_2QSiZ$ such as $(CH_3)_2QSiCl$ wherein Q is most preferably the

$$C_6H_5\overset{\overset{O}{\|}}{C}C_6H_4OCH_2CH_2CH_2—$$

group.

The siloxane reactant containing at least two siloxane units and at least one silicon-bonded hydrogen atom for the hydrosilylation reaction with the alkenyloxybenzophenone reactant in said second method can be the organo-hydrogenpolysiloxane reactant denoted above in the first method of this invention. As noted above, this preferred organohydrogenpolysiloxane can be straight chained, branched chained, cyclic or network in structure. The adduct resulting from a hydrosilylation reaction between the alkenyloxybenzophenone reactant and this organohydrogenpolysiloxane reactant is, of course, the organopolysiloxane photosensitizer that is produced by the above-described first method of preparation; however, in the second method of preparation said adduct is further reacted by a siloxane polymerization reaction, with another silane or another siloxane, both free of silicon-bonded Q groups, to produce new organopolysiloxane photosensitizers of this invention. In this second method of preparation the organohydrogenpolysiloxane reactant is preferably cyclic in structure such as $(CH_3HSiO)_4$, i.e. tetramethyl-tetrahydrocyclotetrasiloxane, or $(CH_3HSiO)_3$, i.e. trimethyl-trihydrocyclotrisiloxane, or larger cyclics or mixtures thereof.

In this second method the siloxane reactant containing at least two siloxane units and at least one silicon-bonded hydrogen atom can also be an organohydrogenpolysiloxane further containing silicon-bonded hydroxyl groups or silicon-bonded hydrolyzable groups which are convertible to silicon-bonded hydroxyl groups. These hydrolyzable groups are the same as the Z groups denoted above.

Examples of organohydrogenpolysiloxane reactants containing hydrolyzable groups or hydroxyl groups include hydroxyl-endblocked organohydrogen-polysiloxane such as

$$HO\{(CH_3)_2SiO\}_x\{(CH_3)(H)SiO\}_wH$$

or methoxy-endblocked organohydrogenpolysiloxanes such as

$$(CH_3O)_2(CH_3)SiO\{(CH_3)_2{-}SiO\}_x\{(CH_3)(H)SiO\}_wSi(CH_3)(OCH_3)_2$$

wherein $x$ and $w$ are as noted above.

For hydrosilylation addition reactions in either method of this invention between alkenyloxybenzophenone derivatives and silanes or siloxanes containing hydrogen atoms bonded directly to silicon atoms, catalysts to be used are benzoyl peroxide, di-t-butyl peroxide or other peroxides; platinum, palladium, rhodium, nickel, cobalt or other metals in powdered form or in complexes. Platinum sponge, platinum black, chloroplatinic acid, the reaction product of chloroplatinic acid and alcohol, a complex of chloroplatinic acid and vinyl siloxane and other platinum catalysts are preferably used. This addition reaction is preferably carried out so that the alkenyloxybenzophenone derivative is reacted at 1 mole % or less with respect to the hydrogen atoms bonded to the silicon atoms. This addition reaction can be carried out in the absence or presence of a solvent. Typically, an alkenyloxybenzophenone derivative is first heated and melted, then mixed with a silane or siloxane containing hydrogen atoms bonded to silicon atoms. While these are being vigorously mixed, a catalyst is added to promote the reaction. The addition reaction is completed in a homogeneous system. However, it is preferable to add a solvent such as benzene, toluene or xylene to give a homogeneous starting system for the reaction.

The adduct that is obtained in the first step of the second method of this invention is subsequently further reacted, in a siloxane polymerization reaction, with itself or with another silane bearing at least one silicon-bonded hydrolyzable group or with another siloxane. Said siloxane polymerization reaction can be a hydrolysis and siloxane condensation reaction and/or a siloxane equilibration reaction in the well-known manner. The hydrolysis and condensation can be carried out by conventionally known methods if hydrolyzable groups are present. If hydrolyzable groups are not present, the equilibrium polymerization can be carried out in the presence of a conventionally known basic or acidic catalyst.

Said other silanes or other siloxanes are those which do not contain groups possessing the benzophenone derivative structure. Examples are organotrichlorosilane, diorganodi-chlorosilane, triorganochlorosilane, organotrialkoxysilane, diorganodialkoxysilane, triorganoalkoxysilane, organotriacetoxysilane, diorganodiacetoxysilane, triorganoacetoxysilane, diorgano(methylethylketoxime)silane, tetraorganodialkoxydi-siloxane, pentaorganotrialkoxytrisiloxane, triorganopenta-alkoxytrisiloxane, α, ω-dihydroxydiorganosiloxane oligomer, octaorganocyclotetrasiloxane and hexaorganodisiloxane.

The photopolymerization sensitizers of the present invention can be applied to various photosensitive resins. However, their characteristics are best exhibited when they are applied specifically to photosensitive silicone resins and photosensitive organopolysiloxanes. In other words, the sensitizers widely used conventionally and containing benzophenone, Michler's ketone and benzoin as major ingredients have at most 2% miscibility with photosensitive silicone resins and photosensitive organopolysiloxanes. However, the sensitizers of the present invention are miscible in much larger amounts with the photosensitive silicone resins and photosensitive organopolysiloxanes. In a mixed state with photosensitive silicone resins or photosensitive organopolysiloxanes, they do not separate out or form deposits even after long-term storage. They do not have the problems of conventional sensitizers such as benzophenone and Michler's ketone, in which the sensitizers crystallize out after radiation-hardening. They can be used at high concentrations. A high sensitization effect can be expected.

The miscibilities of the photopolymerization sensitizers of the present invention will be good if the sensitizers are selected so that they have molecular structures or contain organic groups identical or similar to the molecular structures or organic groups of photosensitive silicone resins and photosensitive organopolysiloxanes.

For example, if a photosensitive organopolysiloxane has a linear structure, is liquid and contains methyl groups as the major organic groups, it is preferable to select a photopolymerization sensitizer of the present invention which also has a linear or cyclic structure, is liquid and contains methyl groups as the major organic groups, other than those groups possessing the benzophenone derivative structure.

The sensitizers of the present invention can be applied to those photosensitive silicone resins and photosensitive organopolysiloxanes known to date, such as organopolysiloxanes containing acryloxy groups (Japanese Patent Sho 53(1978)-2911, Japanese Patent Sho 53(1978)-36515, and Japanese Patent Sho 55(1980)-4770), compositions of organopolysiloxanes having SiH bonds and organopolysiloxanes containing unsaturated groups such as vinyl groups (Japanese Patent Sho 52(1977)-40334), and compositions of organopolysiloxanes having mercapto groups and organopolysiloxanes containing unsaturated groups such as vinyl groups (Japanese Patent Sho 54(1979)-43017). The sensitizers of the present invention are highly miscible with all of the photosensitive silicone resins and photosensitive organopolysiloxanes. They can be blended in large amounts. They show a high sensitizing action. In the

present invention, the term "photosensitization" refers to sensitization by ultraviolet rays, electrons and other high-energy rays.

The following examples are disclosed to further illustrate, and to teach how to practice, the present invention. These examples shall not limit the present invention as delineated by the appended claims.

All parts and percentages refer to parts by weight and percentages by weight, unless otherwise indicated. Me denotes the methyl group. Viscosities are the values at 25°C.

Example 1

This example illustrates an organopolysiloxane photosensitizer of this invention, its preparation by the second method of this invention and its use.

4-Hydroxybenzophenone (100 parts) was dissolved in tetrahydrofuran (100 parts). Potassium hydroxide (30.9 parts) was added, heated and stirred until completely dissolved. Allyl chloride (46.4 parts) and potassium iodide (42 parts) were added to this solution. The mixture was refluxed for 8 hours. After cooling, it was washed with water and the solvent removed by distillation. A crude product of the desired 4-allyloxybenzophenone was obtained. It was recrystallized in n-hexane to obtain 110 parts of 4-allyloxybenzophenone (melting point 71°C) at 72% yield.

NMR (a value of δ in carbon tetrachloride) measured values were 4.20 (m, 2H), 4.65—5.20 (m, 2H), 5.30—6.00 (m, 1H) and 6.50—7.50 (m, 9H).

4-Allyloxybenzophenone (2 parts) and tetramethyl tetrahydrogen cyclotetrasiloxane (2 parts) were heated to 80°C. After mixing by stirring, 0.01 part of a 1% chloroplatinic acid solution in tetrahydrofuran (THF) was dripped into it. After stirring for 1 hour, hexamethyldisiloxane (1 part), and octamethylcyclotetrasiloxane (37 parts) were added. Trifluoromethane sulfonic acid (0.01 part) was added as a copolymerization catalyst. After the copolymerization, the solution was neutralized with sodium carbonate and filtered. A photopolymerization sensitizing organopolysiloxane (40 parts) with a viscosity of 200 cp, $n_D^{25}$ 1.4122, and an average composition formula

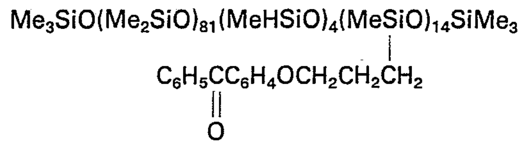

was obtained. This material (0.5 part) was mixed, and was completely miscible, with a photosensitive siloxane resin consisting of a mixture of 5 parts of a trimethylsiloxy-terminated block polymer containing about 78 mole % $Me_2SiO$ units and about 22 mole % $CH_2{=}CHMeSiO$ units, and 0.5 part of a trimethylsiloxy terminated polymer of HMeSiO units. This mixture was made into a film of 10 m thickness and irradiated with ultraviolet rays from 160 W/cm high-voltage mercury lamps from a distance of 10 cm. Hardening was achieved in 10—15 seconds. No separation or deposition of the photopolymerization sensitizer was observed even after storing the hardened material.

Example 2

This example illustrates an organopolysiloxane photosensitizer of this invention, its preparation by the first method of this invention and its use.

4-Allyloxybenzophenone (1 part) and a methylpolysiloxane (10 parts), represented by an average composition formula

$$Me_3SiO(Me_2SiO)_{130}(MeHSiO)_{10}SiMe_3$$

and containing hydrogen atoms bonded to silicon atoms, were heated to 90°C. After mixing by stirring, 0.01 part of a 1% chloroplatinic acid solution in THF was dripped into the mixture. After stirring for 30 minutes, the reaction solution was cooled and filtered to obtain 8 parts of a photopolymerization-sensitizing organopolysiloxane with a viscosity of 230 cp and $n_D^{25}$ 1.4224. This material (0.5 part) was mixed with a photosensitive siloxane resin consisting of a mixture of 6 parts of a dimethylvinylsiloxy terminated polymer of $Me_2SiO$ units, and 4 parts of a trimethylsiloxy-terminated block polymer containing about 97% $Me_2SiO$ units and about 3 mole % mercaptopropylmethylsiloxy units. At this time, the vinyl groups and the mercaptopropyl groups were about 1 mole %. The photopolymerization sensitizer was completely miscible. This composition was made into a film of 10 m thickness and irradiated with ultraviolet rays from 160 W/cm high-voltage mercury lamps from a distance of 10 cm. It hardened rapidly in less than 1 second. Even after storage of the hardened material, no separation or deposition of the photopolymerization sensitizer was observed.

Example 3

4-Allyloxybenzophenone (1 part) and a methylpolysiloxane (20 parts) represented by the average composition formula

$$Me_3SiO(Me_2SiO)_{130}(MeHSiO)_{10}SiMe_3$$

and containing hydrogen atoms bonded to silicon atoms, were heated to 90°C. After mixing by stirring, 0.01 part of a 1% chloroplatinic acid solution in THF was dripped into it. After stirring for 30 minutes, the mixture was cooled and filtered to obtain 18 parts of a photopolymerization-sensitizing organopolysiloxane with a viscosity of 210 cp and $n_D^{25}$ 1.4130. This material (0.5 part) was mixed, and was completely miscible, with a photosensitive siloxane resin consisting of a mixture of 5 parts of a trimethylsiloxy-terminated block polymer containing about 78 mole % $Me_2SiO$ units and about 22 mole % $CH_2{=}CHMeSiO$ units and 0.5 part of a trimethylsiloxy-terminated polymer of HMeSiO units.

This mixture was made into a film of 100 m thickness, and was irradiated with ultraviolet rays from 160 W/cm high-voltage mercury lamps from a distance of 10 cm. It hardened in 5 seconds. Even after storing the hardened material, no separation or deposition of the photopolymerization sensitizer was observed.

Example 4

2-Hydroxy-4-methoxybenzophenone (114 parts) was dissolved in tetrahydrofuran (100 parts). Potassium hydroxide (30.9 parts) was added. By heating and stirring, complete dissolution was achieved. Allyl chloride (46.4 parts) and potassium iodide (4.2 parts) were added to this solution, which was then heated and refluxed for 8 hours. After cooling, it was washed with water and the solvent was removed by distillation. A crude product of the desired 2-allyloxy-4-methoxybenzophenone was obtained. It was recrystallized in n-hexane to obtain 125 parts of 2-allyloxy-4-methoxybenzophenone (melting point 40°C) at 93% yield.

2-Allyl-4-methoxybenzophenone (13 parts), a methylpolysiloxane (20 parts) represented by an average composition formula

$$Me_3SiO(Me_2SiO)_{130}(MeHSiO)_{10}SiMe_3$$

and containing hydrogen atoms bonded to silicon atoms, and toluene (10 parts) were heated to 90°C. After mixing by stirring, 0.01 part of a 1% chloroplatinic acid/THF solution was dripped into it. After stirring for 30 minutes, the solvent was removed by distillation. It was filtered to obtain 18 parts of a photopolymerization-sensitizing organopolysiloxane with a viscosity of 200 cp and $n_D^{25}$ 1.4075. This material (1 part) was mixed and was completely miscible, with a photosensitive siloxane resin consisting of a mixture of 5 parts of a trimethylsiloxy-terminated block polymer containing about 92 mole % $Me_2SiO$ units and about 8 mole % $CH_2{=}CHSiMeO$ units and 0.5 part of a trimethylsiloxy-terminated polymer of HMeSiO units. This mixture was made into a film of 10 m thickness and irradiated with ultraviolet rays from 160 W/cm high-voltage mercury lamps from a distance of 10 cm. It hardened in 1 minute. Even after storage of the hardened material, no separation or deposition of the photopolymerization sensitizer was observed.

**Claims**

1. An organopolysiloxane photosensitizer comprising an average of more than two siloxane units of which at least an average of one siloxane unit per organopolysiloxane molecule has the formula $Q_aR^4_bSiO_{(4-a-b)/2}$, wherein Q denotes a benzocyclic, phenone-containing group having the formula

$$(R^1_mC_6H_{5-m})\overset{O}{\overset{\|}{C}}(C_6H_{4-n}R^2_nOR^3\text{—});$$

$R^1$ and $R^2$ each denote, independently, a hydrogen atom, a halogen atom, a monovalent hydrocarbon group having from 1 to 10 carbon atoms, an alkoxy group, a thioalkoxy group, a hydroxyl group, an amino group or a dialkylamino group; $R^3$ denotes a divalent hydrocarbon group having from 2 to 10 carbon atoms; $R^4$ denotes a monovalent hydrocarbon group or a halogenated monovalent hydrocarbon group; *m* is an integer of from 1 to 5, *n* is an integer of from 1 to 4, *a* is an integer of from 1 to 3, *b* is an integer of from 0 to 2 and *a*+*b* is an integer of from 1 to 3.

2. An organopolysiloxane photosensitizer according to claim 1 wherein any siloxane unit in the organopolysiloxane photosensitizer molecules not bearing a Q group has the formula $R^4_cH_dSiO_{(4-c-d)/2}$ wherein *c*, *d* and *c*+*d* are integers of from 0 to 3.

3. An organopolysiloxane photosensitizer according to claim 2 wherein the average number of Q groups in the organopolysiloxane molecule is equal to from 0.2% to 50% of the total number of Q groups plus $R^4$ groups in the organopolysiloxane molecule.

4. A method for preparing an organopolysiloxane photosensitizer comprising an average of more than two siloxane units, of which at least an average of one siloxane unit per organopolysiloxane molecule has the formula $Q_aR^4_bSiO_{(4-a-b)/2}$, said method characterized by reacting, an alkenyloxybenzophenone reactant having the formula

$$(R^1_mC_6H_{5-m})\overset{O}{\overset{\|}{C}}(C_6H_{4-n}R^2_nOR^5)$$

and an organohydrogenpolysiloxane reactant containing more than two siloxane units and at least one silicon-bonded hydrogen atom per molecule, wherein Q denotes a benzophenone-containing group having the formula

$$(R^1_mC_6H_{5-m})\overset{O}{\overset{\|}{C}}(C_6H_{4-n}R^2_nOR^3\text{—});$$

at each occurrence $R^1$ and $R^2$ denote, independently, a hydrogen atom, a halogen atom, a monovalent hydrocarbon group having from 1 to 10 carbon atoms, an alkoxy group, a thioalkoxy group, a hydroxyl group, an amino group or a dialkylamino group; $R^3$ denotes a divalent hydrocarbon group having from 2 to 10 carbon atoms; $R^4$ denotes a monovalent hydrocarbon group or a halogenated monovalent hydrocarbon group; $R^5$ denotes an aliphatically unsaturated monovalent hydrocarbon group having the same number of carbon atoms as the $R^3$ group; *m* is an integer of from 1 to 5, *n* is an integer of from 1 to 4, *a* is an integer of from 1 to 3, *b* is an integer of from 0 to 2 and *a*+*b* is an integer of from 1 to 3 whereby the $R^5$ group becomes the $R^3$ group during said reaction.

5. A method for preparing an organopolysiloxane photosensitizer comprising an average of more than two siloxane units, of which an average of at least one siloxane unit per organopolysiloxane molecule has the formula $Q_aR^4_bSiO_{(4-a-b)/2}$, said method characterized by

(A) reacting, by a hydrosilylation reaction to form an adduct, an alkenyloxybenzophenone reactant having the formula

$$(R^1_mC_6H_{5-m})\overset{O}{\overset{\|}{C}}(C_6H_{4-n}R^2_nOR^5)$$

and a silane bearing at least one silicon-bonded hydrogen atom and at least one silicon-bonded hydrolyzable group or a siloxane bearing at least two siloxane units and at least one silicon-bonded hydrogen atom; and

(B) polymerizing the adduct or copolymerizing the adduct with another silane bearing at least one silicon bonded hydrolyzable radical or with a siloxane, both being free of Q groups, to provide the organopolysiloxane photosensitizer, wherein Q denotes a benzophenone-containing group having the formula

$$(R^1_mC_6H_{5-m})\overset{O}{\overset{\|}{C}}(C_6H_{4-n}R^2_nOR^3\text{—});$$

at each occurrence $R^1$ and $R^2$ denote, independently, a hydrogen atom, a halogen atom, a monovalent hydrocarbon group having from 1 to 10 carbon atoms, an alkoxy group, a thioalkoxy group, a hydroxyl group, an amino group or a dialkylamino group; $R^3$ denotes a divalent hydrocarbon group having from 2 to 10 carbon atoms; $R^4$ denotes a monovalent hydrocarbon group or a halogenated monovalent hydrocarbon group; $R^5$ denotes an aliphatically unsaturated monovalent hydrocarbon group having the same number of carbon atoms as the $R^3$ group; *m* is an integer of from 1 to 5, *n* is an integer of from 1 to 4, *a* is an integer of from 1 to 3, *b* is an integer of from 0 to 2 and *a*+*b* is an integer of from 1 to 3; the $R^5$ group becoming the $R^3$ group during said hydrosilylation reaction.

**Patentansprüche**

1. Organopolysiloxan-Photosensibilisator, der im Mittel mehr als zwei Siloxaneinheiten enthält, von denen im Mittel mindestens eine Siloxaneinheit pro Organopolysiloxanmolekül die Formel $Q_aR^4_bSiO_{(4-a-b)/2}$ hat, in der Q eine Benzophenon enthaltende Gruppe der Formel

$$(R^1_mC_6H_{5-m})\overset{O}{\overset{\|}{C}}(C_6H_{4-n}R^2_nOR^3)$$

bedeutet in der jedes $R^1$ und $R^2$ unabhängig voneinander ein Wasserstoffatom, ein Halogenatom, ein einwertiger Kohlenwasserstoffrest mit 1 bis 10 Kohlenstoffatomen, eine Alkoxygruppe, eine Thioalkoxygruppe, eine Hydroxylgruppe, eine Aminogrupp oder eine Dialkylaminogruppe sind, $R^3$ ein zweiwertiger

Kohlenwasserstoffrest mit 2 bis 10 Kohlenstoffatomen ist, $R^4$ ein einwertiger Kohlenwasserstoffrest oder ein halogenierter einwertiger Kohlenwasserstoffrest ist und *m* eine ganze Zahl von 1 bis 5, *n* eine ganze Zahl von 1 bis 4, *a* eine ganze Zahl von 1 bis 3, *b* eine ganze Zahl von 0 bis 2 und *a*+*b* eine ganze Zahl von 1 bis 3 bedeuten.

2. Organopolysiloxan-Photosensibilisator nach Anspruch 1, dadurch gekennzeichnet, daß jede Siloxaneinheit des Organopolysiloxan-Photosensibilisatormoleküls, das keine Gruppe Q aufweist, die Formel $R^4_cH_dSiO_{(4-c-d)/2}$ hat, in der *c*, *d* und *c*+*d* ganze Zahlen von 0 bis 3 sind.

3. Organopolysiloxan-Photosensibilisator nach Anspruch 2, dadurch gekennzeichnet, daß im Mittel die Zahl der Q-Gruppen im Organopolysiloxanmolekül gleich ist und von 0,2% bis 50% der Gesamtzahl der Q-Gruppen plus $R^4$-Gruppen in dem Organopolysiloxanmolekül beträgt.

4. Verfahren zum Herstellen eines Organopolysiloxan-Photosensibilisators, der im Mittel mehr als zwei Siloxaneinheiten enthält, von denen im Mittel mindestens eine Siloxaneinheit pro Organopolysiloxanmolekül die Formel $Q_aR^4_bSiO_{(4-a-b)/2}$ hat und das gekennzeichnet ist durch Umsetzen eines Alkenyloxybenzophenon-Reaktionspartners der Formel

$$(R^1_mC_6H_{5-m})\overset{\overset{\displaystyle O}{\|}}{C}(C_6H_{4-n}R^2_nOR^5)$$

und einem Organohydrogenpolysiloxan-Reaktionspartner, der mehr als zwei Siloxaneinheiten und mindestens ein an Silicium gebundenes Wasserstoffatom pro Molekül aufweist, wobei Q eine Benzophenon enthaltende Gruppe der Formel

$$(R^1_mC_6H_{5-m})\overset{\overset{\displaystyle O}{\|}}{C}(C_6H_{4-n}R^2_nOR^3)$$

bedeutet, in der jedes $R^1$ und $R^2$ unabhängig voneinander ein Wasserstoffatom, ein Halogenatom, ein einwertiger Kohlenwasserstoffrest mit 1 bis 10 Kohlenstoffatomen, eine Alkoxygruppe, eine Thioalkoxygruppe, eine Hydroxylgruppe, eine Aminogruppe oder eine Dialkylaminogruppe bedeutet, $R^3$ ein zweiwertiger Kohlenwasserstoffrest mit 2 bis 10 Kohlenstoffatomen ist, $R^4$ ein einwertiger Kohlenwasserstoffrest oder ein halogenierter einwertiger Kohlenwasserstoffrest ist, $R^5$ ein aliphatisch ungesättigter einwertiger Kohlenwasserstoffrest ist, der die gleiche Zahl von Kohlenstoffatomen aufweist wie $R^3$, und wobei *m* eine ganze Zahl von 1 bis 5, *n* eine ganze Zahl von 1 bis 4, *a* eine ganze Zahl von 1 bis 3, *b* eine ganze Zahl von 0 bis 2 und *a*+*b* eine ganze Zahl von 1 bis 3 ist und wobei der $R^5$-Rest während der Reaktion zum $R^3$-Rest wird.

5. Verfahren zum Herstellen eines Organopolysiloxan-Photosensibilisators, der im Mittel mehr als zwei Siloxaneinheiten enthält, von denen im Mittel mindestens eine Siloxaneinheit pro Organopolysiloxanmolekül die Formel $Q_aR^4_bSiO_{(4-a-b)/2}$ hat, das gekennzeichnet ist durch

(A) Umsetzen eines Alkenyloxybenzophenon-Reaktionspartners der Formel

$$(R^1_mC_6H_{5-m})\overset{\overset{\displaystyle O}{\|}}{C}(C_6H_{4-n}R^2_nOR^5)$$

durch eine Hydrosililierungsreaktion, um ein Addukt zu bilden, mit einem Silan, das mindestens ein an Silicium gebundenes Wasserstoffatom und mindestens eine an Silicium gebundenen hydrolisierbaren Rest aufweist oder mit einem Siloxan, das mindestens zwei Siloxangruppen und mindestens ein an Silicium gebundenes Wasserstoffatom aufweist und

(B) Polymerisieren des Adduktes oder Copolymerisieren des Adduktes mit einem anderen Silan, das mindestens ein an Silicium gebundenes hydrolisierbares Radikal aufweist oder mit einem Siloxan, wobei beide keine Q-Gruppen aufweisen, um einen Organopolysiloxan-Photosensibilisator zu bilden, in dem Q eine Benzophenon enthaltende Gruppe der Formel

$$(R^1_mC_6H_{5-m})\overset{\overset{\displaystyle O}{\|}}{C}(C_6H_{4-n}R^2_nOR^3)$$

ist, in der jedes $R^1$ und $R^2$ unabhängig voneinander ein Wasserstoffatom, ein Halogenatom, ein einwertiger Kohlenwasserstoffrest mit 1 bis 10 Kohlenstoffatomen, eine Alkoxygruppe, eine Thioalkoxygruppe, eine Hydroxylgruppe, eine Aminogruppe oder eine Dialkylaminogruppe sind, $R^3$ ein zweiwertiger Kohlenwasserstoffrest mit 2 bis 10 Kohlenstoffatomen ist, $R^4$ ein einwertiger Kohlenwasserstoffrest oder ein halogenierter einwertiger Kohlenwasserstoffrest ist, $R^5$ ein aliphatisch ungesättigter einwertiger Kohlenwasserstoffrest ist, der die gleiche Zahl von Kohlenstoffatomen hat, wie der Rest $R^3$, *m* eine ganze Zahl von 1 bis 5, *n* eine ganze Zahl von 1 bis 4, *a* eine ganze Zahl von 1 bis 3, *b* eine ganze Zahl von 0 bis 2

und $a+b$ eine ganze Zahl von 1 bis 3 ist und wobei der $R^5$-Rest während der Hydrosililierungsreaktion zum $R^3$-Rest wird.

**Revendications**

1. Un photosensibilisateur organopolysiloxane comprenant une moyenne de plus de deux unités siloxanes dont au moins une moyenne d'une unité siloxane par molécule d'organopolysiloxane a la formule $Q_aR^4_bSiO_{(4-a-b)/2}$, où Q est un groupe contenant un radical de benzophénone ayant la formule

$$(R^1_mC_6H_{5-m})\overset{\overset{\displaystyle O}{\|}}{C}(C_6H_{4-n}R^2_nOR^3-);$$

$R^1$ et $R^2$ sont chacun, indépendamment, un atome d'hydrogène, un atome d'halogène, un groupe d'hydrocarbure monovalent ayant de 1 à 10 atomes de carbone, un groupe alcoxy, un groupe thioalcoxy, un groupe hydroxyle, un groupe amino ou un groupe dialkylamino; $R^3$ est un groupe d'hydrocarbure divalent ayant de 2 à 10 atomes de carbone; $R^4$ est un groupe d'hydrocarbure monovalent ou un groupe d'hydrocarbure monovalent halogéné; $m$ est un nombre entier de 1 à 5, $n$ est un nombre entier de 1 à 4, $a$ est un nombre entier de 1 à 3, $b$ est un nombre entier de 0 à 2 et $a+b$ est un nombre entier de 1 à 3.

2. Un photosensibilisateur organopolysiloxane selon la revendication 1, dans lequel toute unité siloxane dans les molécules du photosensibilisateur organopolysiloxane ne portant pas un groupe Q a la formule $R^4_cH_dSiO_{(4-c-d)/2}$ où $c$, $d$ et $c+d$ sont des nombres entiers de 0 à 3.

3. Un photosensibilisateur organopolysiloxane selon la revendication 2, dans lequel le nombre moyen de groupes Q dans la molécule d'organopolysiloxane va de 0,2% à 50% du nombre total de groupes Q et de groupes $R^4$ dans la molécule d'organopolysiloxane.

4. Un procédé de préparation d'un photosensibilisateur organopolysiloxane comprenant une moyenne de plus de deux unités siloxanes, dont au moins une moyenne d'une unité siloxane par molécule d'organopolysiloxane a la formule $Q_aR^4_bSiO_{(4-a-b)/2}$, ce procédé étant caractérisé en ce qu'on fait réagir un réactif alcényloxybenzophénone ayant la formule

$$(R^1_mC_6H_{5-m})\overset{\overset{\displaystyle O}{\|}}{C}(C_6H_{4-n}R^2_nOR^5)$$

et un réactif organohydrogénopolysiloxane contenant plus de deux unités siloxanes et au moins un atome d'hydrogène lié au silicium par molécule, où Q est un groupe contenant un radical de benzophénone ayant la formule

$$(R^1_mC_6H_{5-m})\overset{\overset{\displaystyle O}{\|}}{C}(C_6H_{4-n}R^2_nOR^3-);$$

$R^1$ et $R^2$ sont chacun, indépendamment, un atome d'hydrogène, un atome d'halogène, un groupe d'hydrocarbure monovalent ayant de 1 à 10 atomes de carbone, un groupe alcoxy, un groupe thioalcoxy, un groupe hydroxyle, un groupe amino ou un groupe dialkylamino; $R^3$ est un groupe d'hydrocarbure divalent ayant de 2 à 10 atomes de carbone; $R^4$ est un groupe d'hydrocarbure monovalent ou un groupe d'hydrocarbure monovalent halogéné; $R^5$ est un groupe d'hydrocarbure monovalent aliphatiquement insaturé ayant le même nombre d'atomes de carbone que le groupe $R^3$; $m$ est un nombre entier de 1 à 5, $n$ est un nombre entier de 1 à 4, $a$ est un nombre entier de 1 à 3, $b$ est un nombre entier de 0 à 2 et $a+b$ est un nombre entier de 1 à 3, de manière que le groupe $R^5$ devienne le groupe $R^3$ pendant cette réaction.

5. Un procédé de préparation d'un photosensibilisateur organopolysiloxane comprenant une moyenne de plus de deux unités siloxanes dont une moyenne d'au moins une unité siloxane par molécule d'organopolysiloxane a la formule $Q_aR^4_bSiO_{(4-a-b)/2}$, procédé caractérisé en ce que:

(A) on fait réagir, par une réaction d'hydrosilylation pour former un produit d'addition, un réactif alcényloxybenzophénone ayant la formule

$$(R^1_mC_6H_{5-m})\overset{\overset{\displaystyle O}{\|}}{C}(C_6H_{4-n}R^2_nOR^5)$$

et un silane portant au moins un atome d'hydrogène lié au silicium et au moins un groupe hydrolysable lié au silicium ou un siloxane portant au moins deux unités siloxanes et au moins un atome d'hydrogène lié au silicium; et

(B) on polymérise le produit d'addition ou on copolymérise le produit d'addition avec un autre silane portant au moins un radical hydrolysable lié au silicium ou avec un siloxane, les deux étant exempts de

groupes Q, pour former le photosensibilisateur organopolysiloxane, où Q est un groupe contenant un radical de benzophénone ayant la formule

$$(R^1_mC_6H_{5-m})\overset{\overset{\displaystyle O}{||}}{C}(C_6H_{4-n}R^2_nOR^3\text{—});$$

$R^1$ et $R^2$ sont chacun, indépendamment, un atome d'hydrogène, un atome d'halogène, un groupe d'hydrocarbure monovalent ayant de 1 à 10 atomes de carbone, un groupe alcoxy, un groupe thioalcoxy, un groupe hydroxyle, un groupe amino ou un groupe dialkylamino; $R^3$ est un groupe d'hydrocarbure divalent ayant de 2 à 10 atomes de carbone; $R^4$ est un groupe d'hydrocarbure monovalent ou un groupe d'hydrocarbure monovalent halogéné; $R^5$ est un groupe d'hydrocarbure monovalent aliphatiquement insaturé ayant le même nombre d'atomes de carbone que le groupe $R^3$; *m* est un nombre entier de 1 à 5, *n* est un nombre entier de 1 à 4, *a* est un nombre entier de 1 à 3, *b* est un nombre entier de 0 à 2 et *a*+*b* est un nombre entier de 1 à 3; le groupe $R^5$ devenant le groupe $R^3$ pendant cette réaction d'hydrosilylation.